# EUROPEAN PATENT SPECIFICATION

(11) **EP 3 976 746 B1**
(45) Date of publication and mention of the grant of the patent: **08.07.2026**
(21) Application number: 20819146.0
(22) Date of filing: 27.05.2020
(51) Int. Cl.: C09K 13/02, H10P 50/66

(54) **ETCHING COMPOSITIONS**
ÄTZZUSAMMENSETZUNGEN
COMPOSITIONS DE GRAVURE

(30) Priority: 03.06.2019 US 201962856213 P
(43) Date of publication of application: 06.04.2022
(73) Proprietor: FUJIFILM Electronic Materials U.S.A, Inc., North Kingstown, Rhode Island 02852 (US)
(72) Inventor: GUSKE, Joshua, Mesa, Arizona 85215 (US); MIZUTANI, Atsushi, Shizuoka 426-0079 (JP)
(74) Representative: Fish & Richardson P.C.
(86) International application number: PCT/US2020/034617
(87) International publication number: WO 2020/247216

(56) References cited:
- US-A1- 2004 061 092
- US-A1- 2011 230 053
- US-A1- 2015 267 306
- US-B2- 7 442 324
- US-B2- 7 470 444
- US-B2- 8 057 696
- US-B2- 8 092 707

## Description

### CROSS-REFERENCE TO RELATED APPLICATION

The present application claims priority to U.S. Provisional Application Serial No. 62/856,213, filed on June 3, 2019.

### FIELD OF THE DISCLOSURE

The present disclosure relates to etching compositions and processes of using etching compositions. In particular, the present disclosure relates to etching compositions that can selectively etch tantalum nitride (TaN) in the presence of other exposed or underlying materials, such as metal conductors (e.g., copper), barrier materials, insulator materials (e.g., low-k dielectric materials).

### BACKGROUND OF THE DISCLOSURE

The semiconductor industry is rapidly decreasing the dimensions and increasing the density of electronic circuitry and electronic components in microelectronic devices, silicon chips, liquid crystal displays, MEMS (Micro Electro Mechanical Systems), printed wiring boards, and the like. The integrated circuits within them are being layered or stacked with constantly decreasing thicknesses of the insulating layer between each circuitry layer and smaller and smaller feature sizes. As the feature sizes have shrunk, patterns have become smaller, and device performance parameters tighter and more robust. As a result, various issues which heretofore could be tolerated, can no longer be tolerated or have become more of an issue due to the smaller feature size.

In the production of advanced integrated circuits, to minimize problems associated with the higher density and to optimize performance, both high k and low k insulators, and assorted barrier layer materials have been employed.

Tantalum nitride (TaN) is utilized for semiconductor devices, liquid crystal displays, MEMS (Micro Electro Mechanical Systems), printed wiring boards and the like, and as ground layers and cap layers for precious metal, aluminum (Al) and copper (Cu) wiring. In semiconductor devices, it may be used as a barrier metal, a hard mask, or a gate material.

In the construction of devices for these applications, TaN frequently needs to be etched. In the various types of uses and device environments of TaN, other layers are in contact with or otherwise exposed at the same time as TaN is etched. Highly selective etching of the TaN in the presence of these other materials (e.g. metal conductors, dielectric, and hard marks) is generally required for device yield and long life. The etching process for TaN may be a plasma etching process. However, using a plasma etching process on the TaN layer may cause damage to either or both the gate insulating layer and the semiconductor substrate. In addition, the etching process may remove a portion of the semiconductor substrate by etching the gate insulating layer exposed by the gate electrode. The electrical characteristics of the transistor may be negatively impacted. To avoid such etching damage, additional protective device manufacturing steps may be employed, but at a significant cost.

Wet etching methods for TaN are known. Such methods may include use of etchants in combination with other reagents. However, their selectivity with silicon based dielectrics and metals (e.g., Cu) is not sufficient and other exposed metals in the device may also undergo corrosion or etching.

US 2004/0061092 A1 describes a wet etchant solution for etching of alumina in the presence of transition metals.

Thus, there is a need for etching solutions that have a high TaN etch rate, but have low etch and corrosion rates for other semiconductor materials which are exposed or in contact with the Ta or TaN during the etching process.

### SUMMARY OF THE DISCLOSURE

The present invention is defined by the independent claims. Th dependent claims depict additional embodiments of the invention.

The present disclosure is based on the unexpected discovery that certain etching compositions can selectively etch TaN relative to metal conductor layers, hard mask layers and low-k dielectric layers that are present in the semiconductor device. More specifically, the present disclosure relates to compositions and processes for selectively etching TaN relative to copper, cobalt, and/or ruthenium.

In one aspect, the disclosure features an etching composition that includes 1) an oxidizing agent; 2) a hydroxylcarboxylic acid comprising at least two carboxyl groups; 3) an anionic surfactant comprising a compound of formula (I): 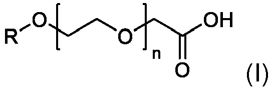 or a salt thereof, in which R is C₁-C₁₄ alkyl and n is an integer ranging from 1 to 14; and 4) water, in which the composition is free of an abrasive and has a pH of from about 7 to about 10.

In another aspect, the disclosure features a method that includes
contacting a semiconductor substrate containing a TaN feature with an etching composition to remove at least a portion of the TaN feature, wherein the etching composition comprises 1) an oxidizing agent; 2) a hydroxylcarboxylic acid comprising at least two carboxyl groups; 3) an anionic surfactant; and 4) water; and wherein the composition is free of an abrasive and has a pH of from about 7 to about 10.

### DETAILED DESCRIPTION OF THE DISCLOSURE

As defined herein, unless otherwise noted, all percentages expressed should be understood to be percentages by weight to the total weight of the composition. Unless otherwise noted, ambient temperature is defined to be between about 16 and about 27 degrees Celsius (°C).

As defined herein, a "water-soluble" substance (e.g., a water-soluble alcohol, ketone, ester, ether, and the like) refers to a substance having a solubility of at least 0.5% by weight (e.g., at least 1% by weight or at least 5% by weight) in water at 25°C.

Tautomerization is herein defined as the formal migration of a hydrogen atom or proton accompanied by a switch of a single and an adjacent double bond. The mention, description, or claim of triazole compounds also includes the tautomers of the triazole compounds due to the low activation energy for tautomerization in the triazole ring system.

In general, the disclosure features an etching composition (e.g., an etching composition for selectively removing TaN) that includes (e.g., comprises, consists essentially of, or consists of) 1) an oxidizing agent; 2) a hydroxylcarboxylic acid containing at least two carboxyl groups; 3) an anionic surfactant comprising a compound of formula (I): 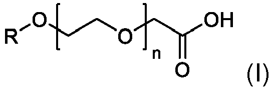 or a salt thereof, in which R is C₁-C₁₄ alkyl and n is an integer ranging from 1 to 14; and 4) water; in which the composition is free of an abrasive and has a pH of from about 7 to about 10.

The etching composition of this disclosure includes at least one (e.g., two, three, or four) oxidizing agent suitable for use in microelectronic applications. Examples of suitable oxidizing agents include, but are not limited to, oxidizing acids or salts thereof (e.g., nitric acid, permanganic acid, or potassium permanganate), peroxides (e.g., hydrogen peroxide, dialkylperoxides, urea hydrogen peroxide), persulfonic acid (e.g., hexafluoropropanepersulfonic acid, methanepersulfonic acid, trifluoromethanepersulfonic acid, or p-toluenepersulfonic acid) and salts thereof, ozone, peroxycarboxylic acids (e.g., peracetic acid) and salts thereof, perphosphoric acid and salts thereof, persulfuric acid and salts thereof (e.g., ammonium persulfate or tetramethylammonium persulfate), perchloric acid and salts thereof (e.g., ammonium perchlorate, sodium perchlorate, or tetramethylammonium perchlorate)), and periodic acid and salts thereof (e.g., periodic acid, ammonium periodate, or tetramethylammonium periodate). These oxidizing agents can be used singly or in combination.

In some embodiments, the at least one oxidizing agent can be from at least about 10 wt% (e.g., at least about 12 wt%, at least about 14 wt%, at least about 15 wt%, at least about 16 wt%, at least about 18 wt%, or at least about 20 wt%) to at most about 30 wt% (e.g., at most about 28 wt%, at most about 26 wt%, at most about 25 wt%, at most about 24 wt%, at most about 22 wt%, or at most about 20 wt%) of the total weight of the etching composition of this disclosure. Without wishing to be bound by theory, it is believed that the oxidizing agent can facilitate and enhance the removal of TaN on a semiconductor substrate (e.g., by forming a TaOx type material that can be dissolved in the etching composition).

The etching composition of this disclosure includes at least one (e.g., two, three, or four) hydroxylcarboxylic acid. In some embodiments, the hydroxylcarboxylic acid can include at least two (e.g., three or four) carboxyl (COOH) groups and/or at least one (e.g., two or three) hydroxyl (OH) groups. In some embodiments, the hydroxylcarboxylic acid can be non-aromatic and/or non-cyclic (e.g., without a ring structure). For example, the hydroxylcarboxylic acid can include citric acid or tartaric acid. In some embodiments, the hydroxylcarboxylic acid described herein exclude those containing only one carboxyl group (e.g., lactic acid or glycolic acid).

In some embodiments, the at least one hydroxylcarboxylic acid can be from at least about 1 wt% (e.g., at least about 2 wt%, at least about 3 wt%, at least about 4 wt%, or at least about 5 wt%) to at most about 10 wt% (e.g., at most about 9 wt%, at most about 8 wt%, at most about 7 wt%, at most about 6 wt%, or at most about 5 wt%) of the total weight of the etching composition of this disclosure. Without wishing to be bound by theory, it is believed that the hydroxylcarboxylic acid can enhance the removal of TaN on a semiconductor substrate.

The etching composition of this disclosure includes at least one (e.g., two, three, or four) anionic surfactant. The anionic surfactant includes a compound of formula (I): 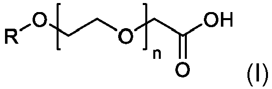 or a salt thereof, in which R is C₁-C₁₄ alkyl (e.g., C₂, C₄, C₆, C₈, C₁₀, or C₁₂ alkyl) and n is an integer ranging from 1 to 14 (e.g., 2, 3, 4, 5, 6, 7, 8, 9, 10, 11, 12, or 13). Specific examples can include poly(oxy-1,2-ethanediyl)-α-(carboxymethyl)-ω-(hexyloxy) (such as a compound of formula (I) in which R is hexyl and n is 3), poly(oxy-1,2-ethanediyl)-α-(carboxymethyl)-ω-(octoxy) (such as a compound of formula (I) in which R is octyl and n is 8), or a salt or combination thereof. Commercially available examples of suitable anionic surfactants include AKYPO series of products (e.g., AKYPO LF 1, AKYPO LF 2, AKYPO LF 4, AKYPO LF 6, AKYPO RLM 25, AKYPO RLM 45 CA, or AKYPO RLM 100) available from Kao Corporation, S.A. (Barcelona, Spain) or EMPICOL series of products (e.g., EMPICOL CBJ or EMPICOL CED5) available from Huntsman Performance Products (The Woodlands, TX, USA). In some embodiments, the anionic surfactant can be a polyacrylic acid. Without wishing to be bound by theory, it is believed that the carboxylic acid group in the compound of formula (I) and polyacrylic acid can be deprotonated in a basic condition to form an anionic surfactant.

In some embodiments, the at least one anionic surfactant can be from at least about 0.001 wt% (e.g., at least about 0.005 wt%, at least about 0.008 wt%, at least about 0.01 wt%, at least about 0.02 wt%, at least about 0.05 wt%, or at least about 0.1 wt%) to at most about 5 wt% (e.g., at most about 4 wt%, at most about 3 wt%, at most about 2 wt%, at most about 1 wt%, at most about 0.5 wt%, at most about 0.1 wt%, or at most about 0.05 wt%) of the total weight of the etching composition of this disclosure. Without wishing to be bound by theory, it is believed that the anionic surfactant can reduce or minimize the corrosion or removal of copper on a semiconductor substrate exposed to the etching composition during the etching process.

The etching composition of this disclosure includes water as a solvent (e.g., as the only solvent). In some embodiments, the water can be de-ionized and ultra-pure, contain no organic contaminants and have a minimum resistivity of about 4 to about 17 mega Ohms, or at least about 17 mega Ohms. In some embodiments, the water is in an amount of from at least about 50 wt% (e.g., at least about 55 wt%, at least about 60 wt%, at least about 65 wt%, at least about 70 wt%, at least about 75 wt%, at least about 80 wt%, or at least about 85 wt%) to at most about 90 wt% (e.g., at most about 85 wt%, at most about 80 wt%, at most about 75 wt%, at most about 70 wt%, at most about 65 wt%, at most about 60 wt%, or at most about 55 wt%) of the total weight of the etching composition. Without wishing to be bound by theory, it is believed that, if the amount of water is greater than 90 wt% of the composition, it would adversely impact the TaN etch rate, and reduce its removal during the etching process. On the other hand, without wishing to be bound by theory, it is believed that the etching composition of this disclosure should include a certain level of water (e.g., at least about 50 wt%) to keep all other components solubilized and to avoid reduction in the etching performance.

In some embodiments, the etching composition of this disclosure can include at least one (e.g., two, three, or four) organic solvent. In other embodiments, the etching composition of this disclosure does not include any organic solvent.

In some embodiments, the etching composition of this disclosure can optionally further include at least one (e.g., two, three, or four) metal corrosion inhibitor. Examples of suitable corrosion inhibitors include azole compounds (e.g., substituted or unsubstituted azole compounds) or salts thereof. Examples of azole compounds include triazole compounds, imidazole compounds, thiadiazole compounds, and tetrazole compounds. Triazole compounds can include triazole, benzotriazole, substituted triazole, and substituted benzotriazole. Examples of triazole compounds include, but are not limited to, 1,2,4-triazole, 1,2,3-triazole, or triazoles substituted with substituents such as C₁-C₈ alkyl (e.g., 5-methyltriazole), amino, thiol, mercapto, imino, carboxy and nitro groups. Specific examples of substituted triazole compounds include tolyltriazole, 5-methyl-1,2,4-triazole, 3-amino-5-mercapto-1,2,4-triazole, 1-amino-1,2,4-triazole, 4-amino-1,2,4-triazole, 1-amino-1,2,3-triazole, 1-amino-5-methyl-1,2,3-triazole, 3-amino-1,2,4-triazole, 3-amino-1,2,4-triazole-5-thiol, 3-mercapto-1,2,4-triazole, 3-isopropyl-1,2,4-triazole, and the like.

In some embodiments, the at least one metal corrosion inhibitor can include a benzotriazole optionally substituted by at least one substituent selected from the group consisting of alkyl groups, aryl groups, halogen groups, amino groups, nitro groups, alkoxy groups, and hydroxyl groups. Examples include benzotriazole (or 1H-benzotriazole), 5-aminobenzotriazole, hydroxybenzotriazoles (e.g., 1-hydroxybenzotriazole), 5-phenylthiol-benzotriazole, halo-benzotriazoles (halo = F, Cl, Br or I) (such as 5-chlorobenzotriazole, 4-chlorobenzotriazole, 5-bromobenzotriazole, 4-bromobenzotriazole, 5-fluorobenzotriazole, and 4-fluorobenzotriazole), naphthotriazole, 5-phenyl-benzotriazole, 5-nitrobenzotriazole, 4-nitrobenzotriazole, 2-(5-amino-pentyl)-benzotriazole, 1-amino-benzotriazole, 5-methyl-1H-benzotriazole, 1H-benzotriazole-1-methanol, benzotriazole-5-carboxylic acid, 4-methylbenzotriazole, 4-ethylbenzotriazole, 5-ethylbenzotriazole, 4-propylbenzotriazole, 5-propylbenzotriazole, 4-isopropylbenzotriazole, 5-isopropylbenzotriazole, 4-n-butylbenzotriazole, 5-n-butylbenzotriazole, 4-isobutylbenzotriazole, 5-isobutylbenzotriazole, 4-pentylbenzotriazole, 5-pentylbenzotriazole, 4-hexylbenzotriazole, 5-hexylbenzotriazole, 5,6-dimethyl-1H-benzotriazole, 5-methoxybenzotriazole, 5-hydroxybenzotriazole, dihydroxypropylbenzotriazole, 1-[N,N-bis(2-ethylhexyl)aminomethyl]-benzotriazole, 5-t-butyl benzotriazole, 5-(1',1'-dimethylpropyl)-benzotriazole, 5-(1',1',3'-trimethylbutyl)benzotriazole, 5-n-octyl benzotriazole, and 5-(1',1',3',3'-tetramethylbutyl)benzotriazole.

Examples of imidazole compounds include, but are not limited to, 2-alkyl-4-methyl imidazole, 2-phenyl-4-alkyl imidazole, 2-methyl-4(5)-nitroimidazole, 5-methyl-4-nitroimidazole, 4-imidazolemethanol hydrochloride, and 2-mercapto-1-methylimidazole.

An example of thiadiazole compounds is 2-amino-1,3,4-thiadiazole.

Examples of tetrazole compounds include 1H-tetrazole, 5-methyl-1H-tetrazole, 5-phenyl-1H-tetrazole, 5-amino-1H-tetrazole, 1-phenyl-5-mercapto-1H-tetrazole, 5,5'-bis-1H-tetrazole,1-methyl-5-ethyltetrazole, 1-methyl-5-mercaptotetrazole, 1-carboxymethyl-5-mercaptotetrazole, and the like.

In some embodiments, the at least one metal corrosion inhibitor can be from at least about 0.01 wt% (e.g., at least about 0.02 wt%, at least about 0.05 wt%, at least about 0.1 wt%, at least about 0.2 wt%, at least about 0.3 wt%, at least about 0.4 wt%, or at least about 0.5 wt%) to at most about 10 wt% (e.g., at most about 8 wt%, at most about 5 wt%, at most about 3 wt%, at most about 2.5 wt%, at most about 2 wt%, at most about 1.5 wt%, at most about 1 wt%, at most about 0.8 wt%, or at most about 0.5 wt%) of the total weight of the etching composition of this disclosure. Without wishing to be bound by theory, it is believed that the metal corrosion inhibitor can reduce or minimize the corrosion or removal of copper on a semiconductor substrate exposed to the etching composition during the etching process.

In some embodiments, the etching composition of this disclosure can optionally further include at least one (e.g., two, three, or four) chelating agent. In some embodiments, the chelating agent can include a phosphonic acid or a salt thereof. Specific examples of such chelating agents include hexamethylenediamine tetra(methylenephosphonic acid) or its hexapotassium salt, 1-hydroxyethane-1,1-diphosphonic acid, aminotris(methylenephosphonic acid), ethylenediamine tetra(methylenephosphonic acid), tetramethylenediamine tetra(methylenephosphonic acid), diethylenetriamine penta(methylenephosphonic acid), or a salt thereof.

In some embodiments, the chelating agent can include a polyaminopolycarboxylic acid or a salt thereof. The polyaminopolycarboxylic acid can include at least two (e.g., three or four) amino groups and at least two (e.g., three or four) carboxyl groups. Specific examples of such chelating agents include butylenediaminetetraacetic acid, diethylenetriaminepentaacetic acid (DTPA), ethylenediaminetetrapropionic acid, triethylenetetraminehexaacetic acid, 1,3-diamino-2-hydroxypropane-N,N,N',N'-tetraacetic acid, propylenediaminetetraacetic acid, ethylenediaminetetraacetic acid, trans-1,2-diaminocyclohexane tetraacetic acid, ethylendiamine diacetic acid, ethylendiamine dipropionic acid, 1,6-hexamethylenediamine-N,N,N',N'-tetraacetic acid, N,N-bis(2-hydroxybenzyl)ethylenediamine-N,N-diacetic acid, diaminopropane tetraacetic acid, 1,4,7,10-tetraazacyclododecane-tetraacetic acid, diaminopropanol tetraacetic acid, and (hydroxyethyl)ethylenediaminetriacetic acid.

In some embodiments, the at least one chelating can be from at least about 0.01 wt% (e.g., at least about 0.02 wt%, at least about 0.05 wt%, at least about 0.1 wt%, at least about 0.2 wt%, at least about 0.3 wt%, at least about 0.4 wt%, or at least about 0.5 wt%) to at most about 10 wt% (e.g., at most about 8 wt%, at most about 5 wt%, at most about 3 wt%, at most about 2.5 wt%, at most about 2 wt%, at most about 1.8 wt%, at most about 1.5 wt%, at most about 1 wt%, at most about 0.8 wt%, or at most about 0.5 wt%) of the total weight of the etching composition of this disclosure. Without wishing to be bound by theory, it is believed that the chelating agent can form a complex with metals (e.g., copper) on a semiconductor substrate and reduce or minimize the removal of such metals exposed to the etching composition during the etching process. It is also believed that the chelating agent can help stabilize the oxidizing agent (e.g., a peroxide).

In some embodiments, the etching composition of this disclosure can optionally further include at least one (e.g., two, three, or four) pH adjusting agent, such as an acid or a base. In some embodiments, the pH adjusting agent can be a base containing a metal ion (e.g., an alkali ion). Examples of such metal-containing bases include alkali hydroxides, such as NaOH or KOH. In some embodiments, the pH adjusting agent can be a base free of a metal ion, such as ammonium hydroxide (i.e., NH₄OH). In some embodiments, when the etching composition of this disclosure includes at least two basic pH adjusting agents, the primary pH adjusting agent can be an alkali hydroxide or ammonium hydroxide described above, and a secondary basic pH adjusting agent can be a quaternary ammonium hydroxide (e.g., a tetraalkylammonium hydroxide such as tetramethylammonium hydroxide (TMAH) or tetrabutylammonium hydroxide (TBAH)) or an amidine (such as 1,8-diazabicyclo[5.4.0]-7-undecene (DBU) and 1,5-diazabicyclo[4.3.0]-5-nonene (DBN)).

In some embodiments, the pH adjusting agent can be an organic acid, such as a sulfonic acid (e.g., methanesulfonic acid, trifluoromethanesulfonic acid, and p-toluenesulfonic acid) or a carboxylic acid (e.g., a hydroxylcarboxylic acid such as citric acid). In some embodiments, the pH adjusting agent is not an inorganic acid (e.g., a hydrogen halide).

In general, the pH adjusting agent in the etching composition of this disclosure can be in an amount sufficient to adjust the pH of the etching composition to a desired value. In some embodiments, the pH adjusting agent can be from at least about 1 wt% (e.g., at least about 1.5 wt%, at least about 2 wt%, at least about 2.5 wt%, at least about 3 wt%, at least about 3.5 wt%, at least about 4 wt%, at least about 4.5 wt%, or at least about 5 wt%) to at most about 10 wt% (e.g., at most about 9 wt%, at most about 8 wt%, at most about 7.5 wt%, at most about 7 wt%, at most about 6 wt%, or at most about 5 wt%) of the total weight of the etching composition.

In some embodiments, the etching composition of this disclosure can optionally further include at least one (e.g., two, three, or four) quaternary ammonium salt, such as a tetraalkylammonium salt. Examples of suitable quaternary ammonium salts include (lauryldimethylammonio)acetate, dodecyltrimethylammonium chloride, or benzyldodecyldimethylammonium bromide.

In general, the quaternary ammonium salt in the etching composition of this disclosure can be from at least about 0.01 wt% (e.g., at least about 0.02 wt%, at least about 0.04 wt%, at least about 0.05 wt%, at least about 0.06 wt%, at least about 0.08 wt%, at least about 0.1 wt%, at least about 0.2 wt%, at least about 0.3 wt%, at least about 0.4 wt%, or at least about 0.5 wt%) to at most about 1 wt% (e.g., at most about 0.9 wt%, at most about 0.8 wt%, at most about 0.75 wt%, at most about 0.7 wt%, at most about 0.6 wt%, or at most about 0.5 wt%) of the total weight of the etching composition. Without wishing to be bound by theory, it is believed that the quaternary ammonium salt can reduce or minimize the removal of metals exposed to the etching composition during the etching process.

In some embodiments, the etching composition of this disclosure can have a pH of at least about 7 (e.g., at least about 7.2, at least about 7.4, at least about 7.5, at least about 7.6, at least about 7.8, at least about 8, at least about 8.2, at least about 8.4, at least about 8.5, or at least about 9) and/or at most about 10 (e.g., at most about 9.8, at most about 9.6, at most about 9.5, at most about 9.4, at most about 9.2, at most about 9, at most about 8.5, or at most about 8). Without wishing to be bound by theory, it is believed that an etching composition having a pH lower than 7 would not have sufficient TaN etch rate. Further, it is believed that an etching composition having a pH higher than 10 could produce an excessive Cu etch, prevent certain components in the composition from functioning, and/or decompose certain components in the composition due to strong basicity.

In addition, in some embodiments, the etching composition of the present disclosure can contain additives such as, additional corrosion inhibitors, surfactants, additional organic solvents, biocides, and defoaming agents as optional components. Examples of suitable defoaming agents include polysiloxane defoamers (e.g., polydimethylsiloxane), polyethylene glycol methyl ether polymers, ethylene oxide/propylene oxide copolymers, and glycidyl ether capped acetylenic diol ethoxylates (such as those described in U.S. Patent No. 6,717,019). Examples of suitable surfactants may be cationic, anionic, nonionic or amphoteric.

In general, the etching composition of the present disclosure can have a relatively high TaN/metal (e.g., Cu) etch selectivity (i.e., a high ratio of TaN etch rate over metal etch rate). In some embodiments, the etching composition can have a TaN/metal etch selectivity of at least about 2 (e.g., at least about 3, at least about 4, at least about 5, at least about 6, at least about 7, at least about 8, at least about 9, at least about 10, at least about 15, at least about 20, at least about 30, at least about 40, or at least about 50) and/or at most about 500 (e.g., at most about 100).

In some embodiments, the etching composition of the present disclosure can specifically exclude one or more of the additive components, in any combination if more than one. Such components are selected from the group consisting of organic solvents, pH adjusting agents, polymers (e.g., cationic or anionic polymers), oxygen scavengers, quaternary ammonium salts or quaternary ammonium hydroxides, amines, alkaline bases (such as CsOH and RbOH), surfactants other than a defoamer, a defoamer, fluoride containing compounds, abrasives (e.g., cationic or anionic abrasives), silicates, hydroxycarboxylic acids (e.g., those containing more than two hydroxyl groups), carboxylic and polycarboxylic acids (e.g., those containing or lacking amino groups), silanes (e.g., alkoxysilanes), cyclic compounds (e.g., azoles (such as diazoles, triazoles, or tetrazoles), triazines, and cyclic compounds containing at least two rings, such as substituted or unsubstituted naphthalenes, or substituted or unsubstituted biphenylethers), buffering agents, non-azole corrosion inhibitors, and salts (e.g., halide salts or metal salts (e.g., metal halides)).

The etching composition of this disclosure can be prepared by simply mixing the components together, or can be prepared by blending two compositions in a kit. The first composition in the kit can be an aqueous solution of an oxidizing agent (e.g., H₂O₂). The second composition in the kit can contain the remaining components of the etching composition of this disclosure at predetermined ratios in a concentrated form such that the blending of the two compositions will yield a desired etching composition of the disclosure.

In some embodiments, the present disclosure features a method of etching a semiconductor substrate containing at least one TaN feature (e.g., a TaN film or layer). In some embodiments, the TaN feature can be a liner or barrier (e.g., having a thickness of about 1 nm) around a via or trench filled with Cu, Co and/or Ru, or a film coating sidewalls of a via or trench filed with Cu, Co, and/or Ru. Examples of features containing TaN and having materials arranged in the order of filled metal/liner/barrier include Cu/TaN/TaN, Cu/Ta/TaN, Cu/Co/TaN, and Co/Ru/TaN. An example of a feature containing TaN and having materials arranged in the order of filled metal/barrier is Co/TaN.

The method includes contacting a semiconductor substrate containing the at least one TaN feature with an etching composition to remove at least a portion of the TaN feature, wherein the etching composition comprises 1) an oxidizing agent; 2) a hydroxylcarboxylic acid comprising at least two carboxyl groups; 3) an anionic surfactant; and 4) water; and wherein the composition is free of an abrasive and has a pH of from about 7 to about 10. The method can further include rinsing the semiconductor substrate with a rinse solvent after the contacting step and/or drying the semiconductor substrate after the rinsing step. In some embodiments, an advantage of the method described herein is that it does not substantially remove metals (e.g., Cu) on a semiconductor substrate exposed to the etching composition during the etching process.

In some embodiments, the etching method includes the steps of:
(A) providing a semiconductor substrate containing a TaN feature;
(B) contacting the semiconductor substrate with an etching composition described herein;
(C) rinsing the semiconductor substrate with one or more suitable rinse solvents; and
(D) optionally, drying the semiconductor substrate (e.g., by any suitable means that removes the rinse solvent and does not compromise the integrity of the semiconductor substrate).

Semiconductor substrates described herein (e.g., wafers) typically are constructed of silicon, silicon germanium, Group III-V compounds such as GaAs, or any combination thereof. The semiconductor substrates can additionally contain exposed integrated circuit structures such as interconnect features (e.g., metal lines and dielectric materials). Metals and metal alloys used for interconnect features include, but are not limited to, aluminum, aluminum alloyed with copper, copper, titanium, tantalum, cobalt, silicon, titanium nitride, tantalum nitride, and tungsten. The semiconductor substrates may also contain layers of interlayer dielectrics (ILD), polysilicon, silicon oxide, silicon nitride, silicon carbide, titanium oxide, and carbon doped silicon oxides.

A semiconductor substrate can be contacted with the etching composition by any suitable method, such as placing the etching composition into a tank and immersing and/or submerging the semiconductor substrate into the etching composition, spraying the etching composition onto the semiconductor substrate, streaming the etching composition onto the semiconductor substrate, or any combinations thereof.

The etching composition of the present disclosure can be effectively used up to a temperature of about 85°C (e.g., from about 20°C to about 80°C, from about 55°C to about 65°C, or from about 60°C to about 65°C). The etch rates of TaN increase with temperature in this range, thus the processes at a higher temperature can be run for shorter times. Conversely, lower etching temperatures typically require longer etching times.

Etching times can vary over a wide range depending on the particular etching method, thickness, and temperature employed. When etching in an immersion batch type process, a suitable time range is, for example, up to about 10 minutes (e.g., from about 1 minute to about 7 minutes, from about 1 minute to about 5 minutes, or from about 2 minutes to about 4 minutes). Etching times for a single wafer process can range from about 30 seconds to about 5 minutes (e.g., from about 30 seconds to about 4 minutes, from about 1 minute to about 3 minutes, or from about 1 minute to about 2 minutes).

To further promote the etching ability of the etching composition of the present disclosure, mechanical agitation means can be employed. Examples of suitable agitation means include circulation of the etching composition over the substrate, streaming or spraying the etching composition over the substrate, and ultrasonic or megasonic agitation during the etching process. The orientation of the semiconductor substrate relative to the ground can be at any angle. Horizontal or vertical orientations are preferred.

Subsequent to the etching, the semiconductor substrate can be rinsed with a suitable rinse solvent for about 5 seconds up to about 5 minutes with or without agitation means. Multiple rinse steps employing different rinse solvents can be employed. Examples of suitable rinse solvents include, but are not limited to, deionized (DI) water, methanol, ethanol, isopropyl alcohol, N-methylpyrrolidinone, gamma-butyrolactone, dimethyl sulfoxide, ethyl lactate and propylene glycol monomethyl ether acetate. Alternatively, or in addition, aqueous rinses with pH>8 (such as dilute aqueous ammonium hydroxide) can be employed. Examples of rinse solvents include, but are not limited to, dilute aqueous ammonium hydroxide, DI water, methanol, ethanol, and isopropyl alcohol. The rinse solvent can be applied using means similar to that used in applying an etching composition described herein. The etching composition may have been removed from the semiconductor substrate prior to the start of the rinsing step or it may still be in contact with the semiconductor substrate at the start of the rinsing step. In some embodiments, the temperature employed in the rinsing step is between 16°C and 27°C.

Optionally, the semiconductor substrate is dried after the rinsing step. Any suitable drying means known in the art can be employed. Examples of suitable drying means include spin drying, flowing a dry gas across the semiconductor substrate, heating the semiconductor substrate with a heating means such as a hotplate or infrared lamp, Marangoni drying, rotagoni drying, isopropyl alcohol (IPA) drying or any combinations thereof. Drying times will be dependent on the specific method employed but are typically on the order of 30 seconds up to several minutes.

In some embodiments, the etching method described herein further includes forming a semiconductor device (e.g., an integrated circuit device such as a semiconductor chip) from the semiconductor substrate obtained by the method described above.

The present disclosure is illustrated in more detail with reference to the following examples.

### EXAMPLES

Any percentages listed are by weight (wt%) unless otherwise specified. Controlled stirring during testing was done with a 2.54 cm (1 inch) stirring bar at 300 rpm unless otherwise noted.

### GENERAL PROCEDURE 1

### Formulation blending

Samples of etching compositions were prepared by adding, while stirring, to the calculated amount of the solvent the remaining components of the formulation. After a uniform solution was achieved, optional additives, if used, were added.

### GENERAL PROCEDURE 2

### Materials and Methods

Blanket test coupons were evaluated for etching and materials compatibility in the test solutions prepared by General Procedure 1 according to the procedures described in General Procedure 3.

Blanket film etch rate measurements on films were carried out using commercially available unpatterned 300 mm diameter wafers that were diced into 0.5"x1.0" test coupons for evaluation. The blanket film materials used for testing were (1) a tantalum nitride (TaN) film of about 500 Å thickness deposited on a silicon substrate, (2) a copper (Cu) film of about 1500 Å thickness deposited on a silicon substrate, (3) a tantalum oxide (TaOx) film of about 200 or 350 Å thickness deposited on a silicon substrate, (4) a ruthenium (Ru) film of about 350 Å thickness deposited on a silicon substrate, and (5) a cobalt (Co) film of about 2000 Å thickness deposited on a silicon substrate.

The blanket film test coupons were measured for pre-treatment and post-treatment thickness to determine blanket film etch rates. The thicknesses of the TaN, Cu, Co, and Ru films were measured pre-treatment and post-treatment by using a CDE RESMAP 4 point probe. The thickness of the TaOx films were measured pre-treatment and post-treatment using ESM-300 Ellipsometer from J.A. Woolam Co., Inc. (Lincoln, NE). Additional film thickness measurements were collected by X-ray Reflectometry, using a Rigaku SmartLab X-ray Diffractometer.

Patterned test coupons were evaluated for etching and materials compatibility in the test solutions prepared by General Procedure 1 according to the procedures described in General Procedure 3.

Patterned test coupons Cu/Ta (3 nm)/TaN (3 nm)/ILD were evaluated for materials compatibility and/or etching responses. The post-treatment test coupons were then subjected to evaluation by scanning electron microscopy (SEM). The SEM images from the post treatment coupon were compared to a previously taken pre-treatment SEM image set to evaluate materials compatibility and etching response of each test formulation with the patterned test device features.

### GENERAL PROCEDURE 3

### Etching evaluation with beaker test

All blanket film etch testing was carried out between 20°C and 85°C in a 250 mL glass beaker containing 100 g of a sample solution with continuous stirring at 300 rpm, with the Parafilm^{®} cover in place at all times to minimize evaporative losses. All blanket test coupons having a blanket metal or dielectric film exposed on one side to the sample solution were diced by diamond scribe into approximately 0.5" x 1" rectangular test coupon size for beaker scale testing. Each individual test coupon was held into position using a single 4" long, locking plastic tweezers clip. The test coupon, held on one edge by the locking tweezers clip, was suspended into the 250 mL glass beaker and immersed into the 100 g test solution while the solution was stirred continuously at 300 rpm at the process temperature. Immediately after each sample coupon was placed into the stirred solution, the top of the 250 mL glass beaker was covered and resealed with Parafilm^{®}. The test coupons were held static in the stirred solution until the treatment time (as described in General Procedures 3A) had elapsed. After the treatment time in the test solution had elapsed, the sample coupons were immediately removed from the 250 mL glass beaker and rinsed according to General Procedure 3A. After the final DI rinse step, all test coupons were subject to a filtered nitrogen gas blow off step using a hand held nitrogen gas blower which forcefully removed all traces of DI water to produce a final dry sample for test measurements.

### General Procedure 3A (blanket test coupons)

Immediately after a treatment time (i.e., 5 or 6 minutes for TaN and 10 or 20 minutes for Cu, Ru, Co, and TaOx) according to General Procedure 3, the coupon was immersed in a 1000 mL volume of ultra-high purity deionized (DI) water with ~1 liter/min overflow rate at 20°C for 30 seconds and then for an additional 30 seconds with mild agitation. The processing was completed according to General Procedure 3.

### General Procedure 3B (patterned test coupons)

Immediately after a treatment time of 2.5-3 minutes (depending on the experiment) the patterned test coupon was immersed in isopropyl alcohol (IPA) or ultra-high purity deionized water at 20°C for 20 seconds with mild agitation to affect an post-treatment rinse. The processing was completed according to General Procedure 3.

### Example 1

Formulation Examples 1-47 (FE-1 to FE-47) were prepared according to General Procedure 1, and evaluated using blanket test coupons according to General Procedures 2 and 3, except that the etching temperature was 56-67°C. The formulations are summarized in Table 1 and the test results are summarized in Table 2.

**Table 1**

| **Ex.** | **Dequest 2054** | **1,2,3-triazole** | **AKYPO LF4** | **Corrosion Inhibitor** | **DTPA** | **Citric acid** | **KOH** | **H₂O₂** | **Water** | **pH** |
|---|---|---|---|---|---|---|---|---|---|---|
| **FE-1** | 0% | 0.1% | 0.18% | 0.25% BTA | 0.76% | 5.54% | 6.02% | 20.78% | 66.37% | 8.48 |
| **FE-2** | 0% | 0.1% | 0.18% | 0.25% BTA | 1.52% | 5.56% | 6.49% | 20.22% | 65.68% | 8.5 |
| **FE-3** | 0% | 0.1% | 0.18% | 0.28% 5-MBTA | 1.52% | 5.57% | 6.44% | 20.23% | 65.67% | 8.51 |
| **FE-4** | 0% | 0.1% | 0% | 0.28% 5-MBTA | 1.52% | 5.57% | 6.46% | 20.28% | 65.79% | 8.5 |
| **FE-5** | 0% | 0.12% | 0.02% | 0.51% 5-MBTA | 0% | 4.85% | 4.86% | 20.98% | 68.65% | 8.2 |
| **FE-6** | 0% | 0.12% | 0.24% | 0.51% 5-MBTA | 0% | 4.96% | 4.69% | 21.24% | 68.45% | 8.45 |
| **FE-7** | 0% | 0.12% | 0.24% | 0.51% 5-MBTA | 0% | 4.05% | 4.82% | 21.3% | 69.17% | 8.58 |
| **FE-8** | 0% | 0.09% | 0.27% | 0.45% BTA | 0.68% | 5% | 5.04% | 21.15% | 67.31% | 8 |
| **FE-9** | 0.82% | 0.08% | 0.16% | 0.33% 5-MBTA | 1.24% | 4.49% | 5.38% | 20.24% | 68.22% | 8.63 |
| **FE-10** | 0% | 0.08% | 0.16% | 0.33% 5-MBTA | 1.25% | 4.52% | 5.45% | 20.39% | 67.95% | 8.63 |
| **FE-11** | 0% | 0% | 0.17% | 0.51% 5-MBTA | 0% | 4.64% | 4.97% | 20.91% | 68.96% | 8.62 |
| **FE-12** | 0% | 0.08% | 0.17% | 0.34% 5-MBTA | 0% | 4.65% | 4.93% | 20.95% | 69.033% | 8.6 |
| **FE-13** | 0% | 0.08% | 0.17% | 0.42% 5-MBTA | 0% | 4.64% | 4.93% | 20.93% | 68.98% | 8.6 |
| **FE-14** | 0% | 0.08% | 0.17% | 0.51% 5-MBTA | 0% | 4.63% | 4.959% | 20.889% | 68.915% | 8.61 |
| **FE-15** | 0% | 0.08% | 0.17% | 0.59% 5-MBTA | 0% | 4.63% | 4.97% | 20.87% | 68.84% | 8.6 |
| **FE-16** | 1.23% | 0.12% | 0.024% | 0.396% 5-MBTA | 1.125% | 4.961% | 6.188% | 19.332% | 66.625% | 8.83 |
| **FE-17** | 0.41% | 0.04% | 0.024% | 0.264% 5-MBTA | 1.125% | 4.961% | 6.188% | 19.332% | 67.657% | 8.81 |
| **FE-18** | 0.41% | 0.12% | 0.024% | 0.396% 5-MBTA | 1.375% | 4.059% | 5.063% | 19.332% | 69.222% | 8.52 |
| **FE-19** | 0.82% | 0.04% | 0.024% | 0.264% 5-MBTA | 1.375% | 4.961% | 6.188% | 21.366% | 64.963% | 8.5 |
| **FE-20** | 0.82% | 0.08% | 0.016% | 0.33% 5-MBTA | 1.25% | 4.51% | 5.625% | 20.349% | 67.02% | 8.52 |
| **FE-21** | 1.23% | 0.12% | 0.008% | 0.396% 5-MBTA | 1.375% | 4.059% | 6.188% | 21.366% | 65.259% | 8.93 |
| **FE-22** | 0.41% | 0.04% | 0.008% | 0.33% 5-MBTA | 1.125% | 4.059% | 5.063% | 19.332% | 69.634% | 8.69 |
| **FE-23** | 1.23% | 0.12% | 0.024% | 0.264% 5-MBTA | 1.375% | 4.059% | 5.063% | 19.332% | 68.534% | 8.61 |
| **FE-24** | 0.41% | 0.04% | 0.024% | 0.264% 5-MBTA | 1.125% | 4.961% | 5.063% | 21.366% | 66.748% | 7.49 |
| **FE-25** | 0.41% | 0.12% | 0.024% | 0.396% 5-MBTA | 1.125% | 4.961% | 5.063% | 19.332% | 68.57% | 7.93 |
| **FE-26** | 1.23% | 0.04% | 0.024% | 0.264% 5-MBTA | 1.375% | 4.059% | 5.063% | 21.366% | 66.58% | 8.35 |
| **FE-27** | 1.23% | 0.04% | 0.008% | 0.396% 5-MBTA | 1.375% | 4.961% | 5.063% | 19.332% | 67.596% | 7.26 |
| **FE-28** | 0.41% | 0.04% | 0.008% | 0.396% 5-MBTA | 1.375% | 4.698% | 6.129% | 19.332% | 67.612% | 8.8 |
| **FE-29** | 1.23% | 0.12% | 0.024% | 0.396% 5-MBTA | 1.125% | 4.961% | 5.063% | 21.366% | 65.716% | 7.63 |
| **FE-30** | 1.23% | 0.04% | 0.024% | 0.396% 5-MBTA | 1.375% | 4.961% | 5.063% | 21.366% | 65.546% | 7.63 |
| **FE-31** | 1.23% | 0.04% | 0.008% | 0.264% 5-MBTA | 1.125% | 4.961% | 5.063% | 19.332% | 67.978% | 7.67 |
| **FE-32** | 0.41% | 0.04% | 0.008% | 0.396% 5-MBTA | 1.375% | 4.961% | 5.063% | 21.366% | 66.382% | 7.18 |
| **FE-33** | 0.41% | 0.12% | 0.008% | 0.264% 5-MBTA | 1.375% | 4.961% | 5.063% | 19.332% | 68.468% | 7.29 |
| **FE-34** | 0.41% | 0.12% | 0.008% | 0.264% 5-MBTA | 1.375% | 4.059% | 5.063% | 21.366% | 67.336% | 8.32 |
| **FE-35** | 1.23% | 0.08% | 0.016% | 0.264% 5-MBTA | 1.375% | 4.059% | 6.188% | 19.332% | 67.457% | 9.06 |
| **FE-36** | 0.41% | 0.04% | 0.008% | 0.396% 5-MBTA | 1.375% | 4.961% | 6.188% | 19.332% | 67.291% | 8.8 |
| **FE-37** | 1.23% | 0.04% | 0.008% | 0.396% 5-MBTA | 1.125% | 4.059% | 5.063% | 21.366% | 66.714% | 8.54 |
| **FE-38** | 1.23% | 0.12% | 0.008% | 0.33% 5-MBTA | 1.125% | 4.961% | 6.188% | 21.366% | 64.673% | 8.62 |
| **FE-39** | 0.41% | 0.12% | 0.008% | 0.264% 5-MBTA | 1.125% | 4.059% | 6.188% | 21.366% | 66.461% | 8.97 |
| **FE-40** | 0.41% | 0.04% | 0.008% | 0.396% 5-MBTA | 1.375% | 4.961% | 6.188% | 19.332% | 67.291% | 8.67 |
| **FE-41** | 0% | 0.04% | 0.004% | 0.22% 5-MBTA | 1.125% | 4.63% | 6.03% | 20.1% | 67.851% | 8.78 |
| **FE-42** | 1.23% | 0.04% | 0.024% | 0.396% 5-MBTA | 1.125% | 4.059% | 6.188% | 21.366% | 65.573% | 9.03 |
| **FE-43** | 0.41% | 0.04% | 0.008% | 0.396% 5-MBTA | 1.125% | 4.059% | 6.188% | 19.332% | 68.443% | 9.13 |
| **FE-44** | 1.23% | 0.12% | 0.008% | 0.33% 5-MBTA | 1.125% | 4.961% | 6.188% | 21.366% | 64.673% | 8.56 |
| **FE-45** | 0.41% | 0.04% | 0.008% | 0.396% 5-MBTA | 1.125% | 4.059% | 6.188% | 19.332% | 68.443% | 9 |
| **FE-46** | 0.41% | 0.12% | 0.024% | 0.264% 5-MBTA | 1.375% | 4.059% | 6.188% | 21.355% | 66.195% | 8.83 |
| **FE-47** | 1.23% | 0.12% | 0.008% | 0.264% 5-MBTA | 1.125% | 4.510% | 6.188% | 19.332% | 67.224% | 9.12 |

| | | | | | | | | | | |
|---|---|---|---|---|---|---|---|---|---|---|
| Dequest 2054 = Hexamethylenediamine tetra(methylene phosphonic acid) hexapotassium salt AKYPO LF4 = A mixture of 2-(2-hexyloxy(polyethoxy))acetic acid and 2-(2-octoxy(polyethoxy))acetic acid BTA = Benzotriazole 5-MBTA = 5-Methylbenzotriazole DTPA = Diethylenetriaminepentaacetic acid | | | | | | | | | | |

**Table 2**

| **Ex.** | **TaN ER (Å/min)** | **ECD Cu ER (Å/min)** | **TaOx ER (Å/min)** | **Ru ER (Å/min)** | **Appearance Pre H₂O₂** | **Appearance After H₂O₂** | **Appearance At 60°C** | **Foam On TaN** | **Foam On Cu** |
|---|---|---|---|---|---|---|---|---|---|
| **FE-1** | 33.8 | 2.5 | 0.9 | N/A | N/A | Clear | Clear | None | Med-High |
| **FE-2** | 30.8 | 1.9 | 0.9 | N/A | N/A | Clear | Clear | None | Med-High |
| **FE-3** | 45.2 | 0.7 | 1 | 0 | N/A | Clear | Clear | None | Med-High |
| **FE-4** | 35.6 | 1.6 | 0.9 | N/A | N/A | Clear after 1 hour | Clear | None | None |
| **FE-5** | 38.1 | 0.7 | N/A | 0.01 | Clear | Clear | Clear | N/A | N/A |
| **FE-6** | 35.2 | 1 | N/A | N/A | Clear | Clear | Clear | N/A | N/A |
| **FE-7** | 33.5 | 0.7 | N/A | N/A | Clear | Clear | Clear | N/A | N/A |
| **FE-8** | 19.2 | 1.1 | N/A | N/A | Clear | Clear | Clear | N/A | N/A |
| **FE-9** | 30.8 | 1.2 | 0.8 | N/A | Clear | Clear | Clear | N/A | N/A |
| **FE-10** | 39.9 | 1.2 | 0.7 | 0.004 | Clear | Clear | Clear | N/A | N/A |
| **FE-11** | 40.6 | 1.6 | 0.8 | N/A | Clear | Clear | Clear | N/A | N/A |
| **FE-12** | 40.5 | 1.8 | 0.8 | N/A | Clear | Clear | Clear | N/A | N/A |
| **FE-13** | 44.6 | 1.3 | 0.8 | N/A | Clear | Clear | Clear | N/A | N/A |
| **FE-14** | 44.1 | 1 | 0.8 | 0 | Clear | Clear | Clear | None | Med |
| **FE-15** | 35.3 | 1 | 0.8 | N/A | Clear | PS | Clear | None | None |
| **FE-16** | 21.5 | 0.6 | 0.5 | N/A | Clear | Clear | Clear | None | Low |
| **FE-17** | 19.5 | 0.7 | 0.4 | N/A | Clear | Clear | Clear | None | Low |
| **FE-18** | 18.2 | 0.7 | 0.4 | N/A | Clear | Clear | Clear | None | Low |
| **FE-19** | 19.2 | 1.1 | 0.4 | N/A | Clear | Clear | Clear | None | Low |
| **FE-20** | 20.7 | 1.1 | 0.6 | N/A | Clear | Clear | Clear | None | None |
| **FE-21** | 31.4 | 1.4 | 0.5 | N/A | Clear | Clear | Clear | Low | Low |
| **FE-22** | 12.7 | 0.8 | 0.4 | N/A | Clear | Clear | Clear | None | None |
| **FE-23** | 32.2 | 1.5 | 0.7 | N/A | Clear | Clear | Clear | None | Low |
| **FE-24** | 8.9 | 0.7 | 0.4 | N/A | PS | Clear | Clear | None | None |
| **FE-25** | 8.4 | 0.5 | 0.5 | N/A | PS | PS | Clear | None | None |
| **FE-26** | 7.5 | 0.5 | 0.3 | N/A | Clear | Clear | Clear | None | None |
| **FE-27** | 4.3 | 0.6 | 0.3 | N/A | PS | PS | Clear | None | None |
| **FE-28** | 38.7 | 1.7 | 0.8 | N/A | Clear | Clear | Clear | None | Low |
| **FE-29** | 3 | 0.3 | 0.2 | N/A | PS | PS | Clear | None | None |
| **FE-30** | 2.5 | 0.8 | 0.3 | N/A | PS | PS | Clear | None | None |
| **FE-31** | 1.9 | 0.6 | 0.3 | N/A | PS | PS | Clear | None | None |
| **FE-32** | 1.4 | 0.5 | 0.2 | N/A | PS | PS | Clear | None | None |
| **FE-33** | 0.9 | 0.3 | 0.2 | N/A | PS | PS | Clear | None | None |
| **FE-34** | 35.4 | 1.9 | 1.6 | N/A | Clear | Clear | Clear | None | Low |
| **FE-35** | 28.7 | 2 | 0.5 | N/A | Clear | Clear | Clear | Low | Med |
| **FE-36** | 42.1 | 2.2 | 0.9 | N/A | Clear | Clear | Clear | None | Low |
| **FE-37** | 38.7 | 2.3 | 0.9 | N/A | Clear | Clear | Clear | None | Low |
| **FE-38** | 54.9 | 3.3 | 0.9 | N/A | Clear | Clear | Clear | None | Low |
| **FE-39** | 28.7 | 6.3 | 0.3 | N/A | Clear | Clear | Clear | None | Low |
| **FE-40** | 64.1 | 11.2 | 1.9 | N/A | Clear | Clear | Clear | None | Low |
| **FE-41** | 35 | 13.2 | 0.8 | N/A | Clear | Clear | Clear | None | Low |
| **FE-42** | 62 | 13.6 | 1.2 | N/A | Clear | Clear | Clear | None | Med |
| **FE-43** | 75.4 | 27.6 | 1.1 | N/A | Clear | Clear | Clear | Low | Med |
| **FE-44** | 79.4 | 28.6 | 2.2 | N/A | Clear | Clear | Clear | None | Low |
| **FE-45** | 80.4 | 37.6 | 3.7 | N/A | Clear | Clear | Clear | None | Low |
| **FE-46** | 80.1 | 38.3 | 1.3 | N/A | Hazy | Clear | Clear | Low | Med |
| **FE-47** | 66.6 | 39.6 | 1.2 | N/A | Clear | Clear | Clear | None | Med |

| | | | | | | | | | |
|---|---|---|---|---|---|---|---|---|---|
| ER = Etch rate N/A = Not measured or not available ECD = Electrochemical Deposition PS = Phase Separation | | | | | | | | | |

As shown in Table 2, formulations FE-1 to FE-47 exhibited relatively high TaN etch rates and/or TaN/Cu etch selectivity under the test conditions. In addition, most of these formulations were clear (i.e., no precipitation) before H₂O₂ was added, clear after the H₂O₂ was added, and then still clear at the process temperature. Further, most of these formulations had no or low foaming when used to etch TaN and Cu films.

### Example 2

Formulation Examples 48-50 (FE-48 to FE-50) were prepared according to General Procedure 1, and evaluated using blanket test coupons according to General Procedures 2 and 3, except that the etching temperature was 65°C. The formulations and the test results are summarized in Table 3.

**Table 3**

| **Ex.** | **FE-48** | **FE-49** | **FE-50** |
|---|---|---|---|
| **DTPA** | 0.05% | 0.05% | 0.05% |
| **Citric acid** | 3% | 3% | 3% |
| **PH Adjusting Agent** | KOH 3.88% | TMAH 5.13% | DBU 12.94% |
| **H₂O₂** | 15% | 15% | 15% |
| **Water** | 78.07% | 76.82% | 76.82% |

| **Results** | | | |
|---|---|---|---|
| **pH** | 9.16 | 9.12 | 9.12 |
| **TaN ER (Å/min)** | 53.1 | 0.8 | 0.3 |
| **Cu ER (Å/min)** | 1.4 | 1.2 | 1.0 |

As shown in Table 3, FE-48 (which contained KOH as a pH adjusting agent) exhibited relative high TaN etch rates and relatively low Cu etch rates (i.e., relatively high TaN/Cu etch selectivity) under the test conditions. On the other hand, both FE-49 and FE-50 (which contained metal free bases TMAH and DBU as a pH adjusting agent) exhibited relative low TaN etch rates under the test conditions.

### Example 3

Formulation Examples 51-55 (FE-51 to FE-55) were prepared according to General Procedure 1, and evaluated using blanket test coupons according to General Procedures 2 and 3, except that the etching temperature was 60°C. The formulations and the test results are summarized in Table 4.

**Table 4**

| **Ex.** | **FE-51** | **FE-52** | **FE-53** | **FE-54** | **FE-55** |
|---|---|---|---|---|---|
| **DTPA** | 0.68% | 0.67% | 0.69% | 0.69% | 0.69% |
| **Citric acid** | 5% | 4.95% | 5.04% | 5.03% | 5.09% |
| **AKYPO LF 4** | 0.27% | 0.27% | 0.27% | 0.27% | 0.28% |
| **BTA** | 0.45% | 0.45% | 0.46% | 0.46% | 0.46% |
| **1,2,3-Triazole** | 0.09% | 0.09% | 0.09% | 0.09% | 0.09% |
| **PH Adjusting Agent** | KOH 5.04% | CsOH 13.05% | RbOH 8.7% | NaOH 3.82% | NH₄OH 2.07% |
| **H₂O₂** | 21.15% | 20.92% | 21.3% | 21.25% | 21.5% |
| **Water** | 67.31% | 72.65% | 72.15% | 72.22% | 71.89% |

| Results | | | | | |
|---|---|---|---|---|---|
| **Appearance @RT** | Clear | Clear | Clear | Clear | Clear |
| **Appearance @60°C** | Clear | Clear | H₂O₂ decomposition | Clear | Clear |
| **pH** | 8 | 8 | 8 | 8 | 8 |
| **TaN ER (Å/min)** | 19.2 | 1.77 | 4.88 | 56.0 | 14.0 |
| **ECD Cu ER (Å/min)** | 1.1 | 0.14 | 0.14 | 2.1 | 3.8 |
| **TaN/Cu Selectivity** | 18 | 13 | 35 | 27 | 3.7 |

As shown in Table 4, FE-51, FE-54 and FE-55 (which contained KOH, NaOH, and NH₄OH as a pH adjusting agent) exhibited relative high TaN etch rates and relatively low Cu etch rates (i.e., relatively high TaN/Cu etch selectivity) under the test conditions although Cu was oxidized by FE-55. In addition, the other two tested formulations FE-52 and FE-53 exhibited relative high TaN/Cu etch selectivity under the test conditions.

### Example 4

Formulation Examples 56-58 (FE-56 to FE-58) were prepared according to General Procedure 1, and evaluated using blanket test coupons according to General Procedures 2 and 3, except that the etching temperature was 65°C. The formulations and the test results are summarized in Table 5.

**Table 5**

| **Ex.** | **FE-56** | **FE-57** | **FE-58** |
|---|---|---|---|
| **DTPA** | 0.05% | 0.05% | 0.05% |
| **Citric acid** | 6% | 6% | 6% |
| **KOH** | 0% | 4.1% | 7.23% |
| **H₂O₂** | 15% | 15% | 15% |
| **Water** | 81.95% | 79.27% | 78.07% |

| **Results** | | | |
|---|---|---|---|
| **Appearance @60°C** | Clear | Clear | H₂O₂ decomposition |
| **pH** | 1.55 | 7.84 | 9.16 |
| **TaN ER (Å/min)** | 0.2 | 21.4 | 73.1 |
| **Cu ER (Å/min)** | >450 | 7.3 | 1.4 |

As shown in Table 5, FE-56 (which had a relatively low pH) exhibited relative low TaN etch rates and relatively high Cu etch rates (i.e., relatively low TaN/Cu etch selectivity) under the test conditions. By contrast, the other two tested formulations FE-57 and FE-58 exhibited relative high TaN etch rates and relatively low Cu etch rates (i.e., relatively high TaN/Cu etch selectivity) under the test conditions.

### Example 5

Formulation Examples 59-63 (FE-59 to FE-63) were prepared according to General Procedure 1, and evaluated using blanket test coupons according to General Procedures 2 and 3, except that the etching temperature was 65°C. The formulations and the test results are summarized in Table 6.

**Table 6**

| **Ex.** | **FE-59** | **FE-60** | **FE-61** | **FE-62** | **FE-63** |
|---|---|---|---|---|---|
| **DTPA** | 0.05% | 0.05% | 0.05% | 0.05% | 0.05% |
| **Acid** | Citric Acid 3% | Lactic Acid 3% | Tartaric Acid 3% | Glycolic Acid 3% | None |
| **KOH** | 3.94% | 2.98% | 3.51% | 3.56% | 0.79% |
| **H₂O₂** | 15% | 15% | 15% | 15% | 15% |
| **Water** | 78.01% | 78.97% | 78.44% | 78.39% | 78.39% |

| **Results** | | | | | |
|---|---|---|---|---|---|
| **pH** | 9.28 | 9.24 | 9.22 | 9.24 | 9.2 |
| **TaN ER (Å/min)** | 48.9 | 3.1 | 41.5 | 3.7 | 9.3 |
| **Cu ER (Å/min)** | 5.4 | 34.8 | 6.3 | 90 | 86.2 |

As shown in Table 6, FE-59 and FE-61 (which contained α-hydroxylcarboxylic acid having at least two carboxyl groups) exhibited relative high TaN etch rates and relatively low Cu etch rates (i.e., relatively high TaN/Cu etch selectivity) under the test conditions.

### Example 6

Formulation Examples 64-67 (FE-64 to FE-67) were prepared according to General Procedure 1, and evaluated using blanket test coupons according to General Procedures 2 and 3, except that the etching temperature was 65°C. The formulations and the test results are summarized in Table 7.

**Table 7**

| **Ex.** | **FE-64** | **FE-65** | **FE-66** | **FE-67** |
|---|---|---|---|---|
| **DTPA** | 0.05% | 0.05% | 0.05% | 0.25% |
| **Citric Acid** | 0% | 3% | 6% | 9% |
| **5-MBTA** | 0.1% | 0.1% | 0.1% | 0.1% |
| **KOH** | 0.65% | 2.85% | 4.18% | 4.18% |
| **H₂O₂** | 20% | 20% | 20% | 20% |
| **Water** | 79% | 79% | 74.67% | 71.47% |

| **Results** | | | | |
|---|---|---|---|---|
| **pH** | 8.01 | 8.01 | 8.04 | 8.05 |
| **TaN ER (Å/min)** | 0.2 | 15.7 | 30.1 | 30.4 |
| **Cu ER (Å/min)** | 3.1 | 3.7 | 3.6 | 3.9 |

As shown in Table 7, FE-65 to FE-67 (which contained citric acid) exhibited relative high TaN etch rates and relatively low Cu etch rates (i.e., relatively high TaN/Cu etch selectivity) under the test conditions. On the other hand, FE-64 (which contained no citric acid) exhibited relative low TaN etch rates and relatively low TaN/Cu etch selectivity under the test conditions.

### Example 7

Formulation Examples 68-70 (FE-68 to FE-70) were prepared according to General Procedure 1, and evaluated using blanket test coupons according to General Procedures 2 and 3, except that the etching temperature was 65°C. The formulations and the test results are summarized in Table 8.

**Table 8**

| **Ex.** | **FE-68** | **FE-69** | **FE-70** |
|---|---|---|---|
| **DTPA** | 0.75% | 0.75% | 0.75% |
| **Citric Acid** | 6% | 6% | 6% |
| **Anionic Surfactant** | None | EMPICOL CBJ | EMPICOL CED5 |
| | | 0.1% | 0.1% |
| **BTA** | 0.5% | 0.5% | 0.5% |
| **KOH** | 3% | 3.06% | 3.06% |
| **H₂O₂** | 20.03% | 20.03% | 20.03% |
| **Water** | 70.22% | 70.07% | 70.17% |

| **Results** | | | |
|---|---|---|---|
| **pH** | 7.99 | 8.03 | 8.02 |
| **TaN ER (Å/min)** | 25.3 | 29.6 | 29.2 |
| **Cu ER (Å/min)** | 5.8 | 2.9 | 4.4 |

As shown in Table 8, FE-69 and FE-70 (which contained an anionic surfactant) exhibited relative high TaN etch rates and relatively low Cu etch rates (i.e., relatively high TaN/Cu etch selectivity) compared to FE-68 (which did not contain an anionic surfactant).

### Example 8

Formulation Examples 71-73 (FE-71 to FE-73) were prepared according to General Procedure 1, and evaluated using blanket test coupons according to General Procedures 2 and 3, except that the etching temperature was 65°C. The formulations and the test results are summarized in Table 9.

**Table 9**

| **Ex.** | **FE-71** | **FE-72** | **FE-73** |
|---|---|---|---|
| **DTPA** | 0.75% | 0.75% | 0.75% |
| **Citric Acid** | 6% | 6% | 6% |
| **Anionic Surfactant** | AKYPO LF 2 | AKYPO LF 4 | AKYPO LF 6 |
| | 0.1% | 0.1% | 0.1% |
| **BTA** | 0.5% | 0.5% | 0.5% |
| **KOH** | 3.03% | 3.15% | 3.07% |
| **H₂O₂** | 20.03% | 20.03% | 20.03% |
| **Water** | 69.59% | 69.47% | 69.55% |

| **Results** | | | |
|---|---|---|---|
| **pH** | 8.01 | 8.00 | 8.00 |
| **TaN ER (Å/min)** | 30.6 | 33.5 | 28.6 |
| **Cu ER (Å/min)** | 2.7 | 3.5 | 4.2 |

As shown in Table 9, FE-71 to FE-73 (all of which contained an anionic surfactant) exhibited relative high TaN etch rates and relatively low Cu etch rates (i.e., relatively high TaN/Cu etch selectivity).

### Example 9

Formulation Examples 74-77 (FE-74 to FE-77) were prepared according to General Procedure 1, and evaluated according to General Procedures 2 and 3, except that the etching temperature was 65°C. The formulations and the test results are summarized in Table 10.

**Table 10**

| **Ex.** | **FE-74** | **FE-75** | **FE-76** | **FE-77** |
|---|---|---|---|---|
| **DTPA** | 0.73% | 0.71% | 0.69% | 0.70% |
| **Citric Acid** | 5.37% | 5.21% | 5.08% | 5.12% |
| **Polyacrylic acid (Mw 2000)** | None | 0.09% | 0.46% | 0.47% |
| **Triazole** | BTA | BTA | BTA | 5-MBTA |
| | 0.48% | 0.47% | 0.46% | 0.2% |
| **KOH** | 5.53% | 5.37% | 5.45% | 5.48% |
| **H₂O₂** | 20.05% | 20.05% | 19.94% | 19.96% |
| **Water** | 67.84% | 68.09% | 67.91% | 68.08% |

| **Results** | | | | |
|---|---|---|---|---|
| **pH** | 8.09 | 8.00 | 8.04 | 8.02 |
| **TaN ER (Å/min)** | 28.8 | 20.7 | 22.1 | 23.6 |
| **Cu ER (Å/min)** | 5.4 | 4.3 | 4.4 | 3.1 |

As shown in Table 10, FE-74 to FE-77 (all of which contained polyacrylic acid as an anionic surfactant) exhibited relative high TaN etch rates and relatively low Cu etch rates (i.e., relatively high TaN/Cu etch selectivity).

### Example 10

Formulation Examples 78-91 (FE-78 to FE-91) were prepared according to General Procedure 1, and evaluated using blanket test coupons according to General Procedures 2 and 3, except that the etching temperature was 65°C. FE-78 to FE-91 included 0.7% DTPA, 5.5% citric acid, 0.3% AKYPO LF4, KOH, 20% H₂O₂, 0-2 azole additives, and balance water. The azole additives and the test results are summarized in Table 11.

**Table 11**

| **Ex.** | **Azole additive 1** | **Azole additive 2** | **TaN ER (Å/min)** | **Cu ER (Å/min)** | **Co ER (Å/min)** |
|---|---|---|---|---|---|
| **FE-78** | None | None | 30.6 | >100 | >100 |
| **FE-79** | BTA | None | 31 | 3.3 | 3.2 |
| | 0.5% | | | | |
| **FE-80** | 5-MBTA | None | 31.7 | 2.8 | 0.9 |
| | 0.2% | | | | |
| **FE-81** | 1H-Tetrazole | None | 23 | 16.7 | N/A |
| | 0.1% | | | | |
| **FE-82** | 5-Phenyltetrazole | None | 32.8 | 12.7 | N/A |
| | 0.4% | | | | |
| **FE-83** | BTA | 5-Aminotetrazole | 37.2 | 2.5 | 1.2 |
| | 0.5% | 0.1% | | | |
| **FE-84** | BTA | 1,2,3-Triazole | 28.1 | 1.2 | 0.8 |
| | 0.5% | 0.1% | | | |
| **FE-85** | BTA | 1H-Tetrazole | 32.9 | 2.3 | 2.3 |
| | 0.5% | 0.1% | | | |
| **FE-86** | BTA | 1H-BTA-1-methanol | 24.6 | 1.4 | N/A |
| | 0.5% | 0.1% | | | |
| **FE-87** | BTA | 1,2,4-Triazole | 40.2 | 1.9 | N/A |
| | 0.5% | 0.1% | | | |
| **FE-88** | BTA | 3-Amino-1,2,4-triazole-5-thiol | 27.1 | 1.8 | N/A |
| | 0.5% | 0.1% | | | |
| **FE-89** | BTA | 5,6-Dimethyl-1H-BTA monohydrate | 34.3 | 1.1 | N/A |
| | 0.5% | 0.1% | | | |
| **FE-90** | BTA | 4-Amino-1,2,4-triazole | 27.4 | 1.9 | N/A |
| | 0.5% | | | | |
| **FE-91** | BTA | 2-Amino-1,3,4-thiadiazole | 41.3 | 1.9 | N/A |
| | 0.5% | 0.1% | | | |

As shown in Table 11, FE-79 to FE-91 (which contained at least one triazole) exhibited relative high TaN etch rates and relatively low Cu etch rates (i.e., relatively high TaN/Cu etch selectivity) compared to FE-78 (which contained no triazole) under the test conditions. In addition, FE-83 to FE-91 (which contained two triazoles) generally exhibited higher TaN/Cu etch selectivity than FE-79 to FE-82 (which contained one triazole) under the test conditions.

### Example 11

Formulation Examples 92-95 (FE-92 to FE-95) were prepared according to General Procedure 1, and evaluated using blanket test coupons according to General Procedures 2 and 3, except that the etching temperature was 65°C. The formulations and the test results are summarized in Table 12.

**Table 12**

| **Ex.** | **FE-92** | **FE-93** | **FE-94** | **FE-95** |
|---|---|---|---|---|
| **DTPA** | 0.25% | 0.25% | 0.25% | 0.25% |
| **Citric Acid** | 6% | 6% | 6% | 6% |
| **4-MBTA** | 0.25% | 0.25% | 0.25% | 0.25% |
| **Tetraalkylammonium salt** | None | LDAA | DTAC | BDDAB |
| | | 0.1% | 0.1% | 0.1% |
| **KOH** | 2.84% | 2.87% | 2.79% | 2.89% |
| **H₂O₂** | 20.03% | 20.03% | 20.03% | 20.03% |
| **Water** | 70.64% | 70.61% | 70.68% | 70.58% |

| **Results** | | | | |
|---|---|---|---|---|
| **pH** | 8.09 | 8.10 | 8.02 | 8.03 |
| **TaN ER (Å/min)** | 27.9 | 27.6 | 28.1 | 33.6 |
| **Cu ER (Å/min)** | 5.0 | 4.1 | 3.9 | 1.2 |

| | | | | |
|---|---|---|---|---|
| LDAA = (Lauryldimethylammonio)acetate DTAC = Dodecyl trimethylammonium chloride BDDAB = Benzyldodecyldimethylammonium bromide | | | | |

As shown in Table 12, FE-93 to FE-95 (all of which contained a tetraalkylammonium salt) exhibited higher TaN/Cu etch selectivity than FE-92 (which did not contain a tetraalkylammonium salt) under the test conditions.

### Example 12

Formulation Examples 96-98 (FE-96 to FE-98) were prepared according to General Procedure 1, and evaluated using blanket and patterned test coupons according to General Procedures 2 and 3, except that the etching temperature was 65°C. The formulations and the test results are summarized in Table 13.

**Table 13**

| **Ex.** | **FE-96** | **FE-97** | **FE-98** |
|---|---|---|---|
| **DTPA** | 0.05% | 0.05% | 0.05% |
| **Citric acid** | 6% | 6% | 6% |
| **AKYPO LF 4** | 0.5% | 0.27% | None |
| **Triazole** | BTA | BTA 0.45% | 5-MBTA |
| | 0.5% | 1,2,3-Triazole 0.09% | 0.1% |
| **Dequest 2054** | None | None | 6% |
| **KOH** | 3.11% | 5.09% | 2.93% |
| **TBAH** | None | None | 1.5% |
| **H₂O₂** | 20.03% | 21.12% | 20.03% |
| **Water** | 69.12% | 67.29% | 62.7% |

| **Results** | | | |
|---|---|---|---|
| **pH** | 8 | 8 | 8.01 |
| **Appearance Before H₂O₂** | N/A | Clear | N/A |
| **Appearance After H₂O₂** | Clear | Clear | Clear |
| **Appearance at Process Temp.** | Clear | Clear | Clear |
| **Foaming on TaN** | N/A | Medium | None |
| **Foaming on Cu** | High | Medium | None |
| **TaN ER (Å/min)** | 33.3 | 28.5 | 29.7 |
| **PVD Cu ER (Å/min)** | 2.7 | N/A | 1.4 |
| **ECD Cu ER (Å/min)** | N/A | 1 | 0.4 |
| **Co ER (Å/min)** | N/A | 0.7 | N/A |
| **Patterned coupon evaluation** | SEM and TEM | SEM | SEM |
| **Patterned coupon results** | TaN etched, compatible to Ru, Cu, and ILD | Ta/TaN was removed. Good compatibility to Cu and ILD. Minor ILD rounding and possible residue on Cu. | Ta/TaN was removed. Good compatibility to Cu and ILD. |

| | | | |
|---|---|---|---|
| TBAH = Tetrabutylammonium hydroxide PVD = Physical vapor deposition | | | |

While the invention has been described in detail with reference to certain embodiments thereof, it will be understood that modifications and variations are within the scope of that which is described and claimed.

## Claims

1. An etching composition, comprising:
1) an oxidizing agent;
2) a hydroxylcarboxylic acid comprising at least two carboxyl groups;
3) an anionic surfactant, the anionic surfactant comprising a compound of formula (I): 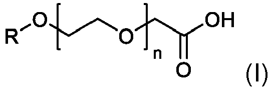 or a salt thereof, in which R is C₁-C₁₄ alkyl and n is an integer ranging from 1 to 14; and
4) water;
wherein the composition is free of an abrasive and has a pH of from about 7 to about 10.

2. The composition of claim 1, wherein the composition has a pH from about 7 to about 9.5.

3. The composition of claim 1 or claim 2, wherein the oxidizing agent comprises a peroxide, a persulfonic acid or a salt thereof, ozone, a peroxycarboxylic acid or a salt thereof, a perphosphoric acid or a salt thereof, a persulfuric acid or a salt thereof, a perchloric acid or a salt thereof, or a periodic acid or a salt thereof, optionally wherein the oxidizing agent comprises hydrogen peroxide or persulfuric acid, and/or wherein the oxidizing agent is in an amount of from about 10% by weight to about 30% by weight of the composition.

4. The composition of any one of claims 1-3, wherein the hydroxylcarboxylic acid is citric acid or tartaric acid, optionally wherein the at hydroxylcarboxylic acid is in an amount of from about 1% by weight to about 10% by weight of the composition.

5. The composition of any one of claims 1-4, wherein the anionic surfactant is in an amount of from about 0.001% by weight to about 5% by weight of the composition.

6. The composition of any one of claims 1-5, wherein the water is in an amount of from about 50% by weight to about 90% by weight of the composition.

7. The composition of any one of claims 1-6, further comprising a metal corrosion inhibitor, optionally wherein the metal corrosion inhibitor comprises an azole or a salt thereof, or optionally wherein the metal corrosion inhibitor comprises 1,2,3-triazole, 1,2,4-triazole, 4-amino-1,2,4-triazole, 3-amino-1,2,4-triazole-5-thiol, 1H-benzotriazole, 5-methyl-1H-benzotriazole, 1H-benzotriazole-1-methanol, 5,6-dimethyl-1H-benzotriazole, 2-amino-1,3,4-thiadiazole, 1H-tetrazole, 5-phenyl-1H-tetrazole, 5-amino-1H-tetrazole, or a combination thereof, and/or wherein the metal corrosion inhibitor is in an amount of from about 0.01% by weight to about 10% by weight of the composition.

8. The composition of any one of claims 1-7, further comprising a chelating agent, optionally wherein the chelating agent is a phosphonic acid or a salt thereof, or optionally wherein the chelating agent is hexamethylenediamine tetra(methylenephosphonic acid), 1-hydroxyethane-1,1-diphosphonic acid, aminotris(methylenephosphonic acid), ethylenediamine tetra(methylenephosphonic acid), tetramethylenediamine tetra(methylenephosphonic acid), diethylenetriamine penta(methylenephosphonic acid), or a salt thereof.

9. The composition of claim 8, wherein the chelating agent comprises a polyaminopolycarboxylic acid, optionally wherein the chelating agent comprises butylenediaminetetraacetic acid, diethylenetriaminepentaacetic acid, ethylenediaminetetrapropionic acid, triethylenetetraminehexaacetic acid, I,3-diamino-2-hydroxypropane-N,N,N',N'-tetraacetic acid, propylenediaminetetraacetic acid, ethylenediaminetetraacetic acid, trans-1,2-diaminocyclohexane tetraacetic acid, ethylendiamine diacetic acid, ethylendiamine dipropionic acid, 1,6-hexamethylenediamine-N,N,N',N'-tetraacetic acid, N,N-bis(2-hydroxybenzyl)ethylenediamine-N,N-diacetic acid, diaminopropane tetraacetic acid, 1,4,7,10-tetraazacyclododecane-tetraacetic acid, diaminopropanol tetraacetic acid, or (hydroxyethyl)ethylenediaminetriacetic acid.

10. The composition of claim 8 or claim 9, wherein the chelating agent is in an amount of from about 0.01% by weight to about 10% by weight of the composition.

11. The composition of any one of claims 1-10, further comprising a pH adjusting agent, optionally wherein the pH adjusting agent comprises a base or an acid, optionally wherein the base is alkali hydroxide or ammonium hydroxide, and/or wherein the pH adjusting agent is in an amount of from about 1% by weight to about 10% by weight of the composition.

12. The composition of any one of claims 1-11, further comprising a quaternary ammonium salt, optionally wherein the quaternary ammonium salt is (lauryldimethylammonio)acetate, dodecyltrimethylammonium chloride, or benzyldodecyldimethylammonium bromide, and/or wherein the quaternary ammonium salt is in an amount of from about 0.01% by weight to about 1% by weight of the composition.

13. A method, comprising:
contacting a semiconductor substrate containing a TaN feature with an etching composition to remove at least a portion of the TaN feature,
wherein the etching composition comprises 1) an oxidizing agent; 2) a hydroxylcarboxylic acid comprising at least two carboxyl groups; 3) an anionic surfactant; and 4) water; and
wherein the composition is free of an abrasive and has a pH of from about 7 to about 10.

14. The method of claim 13, further comprising rinsing the semiconductor substrate with a rinse solvent after the contacting step, optionally further comprising drying the semiconductor substrate after the rinsing step, optionally wherein the method does not substantially remove copper in the semiconductor substrate.

15. The method of claim 13 or claim 14, wherein the anionic surfactant is an alkyl ethoxylated carboxylic acid or a salt thereof, optionally wherein the anionic surfactant is a compound of formula (I): 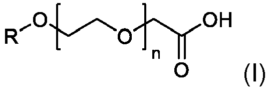 or a salt thereof, in which R is C₁-C₁₄ alkyl and n is an integer ranging from 1 to 14, and/or wherein the anionic surfactant is in an amount of from about 0.001% by weight to about 5% by weight of the composition.

## Patentansprüche

1. Ätzzusammensetzung, die Folgendes umfasst:
1) ein Oxidationsmittel,
2) eine Hydroxylcarbonsäure, die mindestens zwei Carboxylgruppen umfasst,
3) ein anionisches Tensid, wobei das anionische Tensid eine Verbindung der Formel (I): 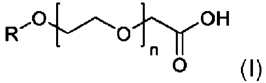 oder ein Salz davon umfasst, wobei R für C₁-C₁₄-Alkyl steht und n für eine ganze Zahl im Bereich von 1 bis 14 steht, und
4) Wasser,
wobei die Zusammensetzung frei von einem Schleifmittel ist und einen pH-Wert von etwa 7 bis etwa 10 aufweist.

2. Zusammensetzung nach Anspruch 1, wobei die Zusammensetzung einen pH-Wert von etwa 7 bis etwa 9,5 aufweist.

3. Zusammensetzung nach Anspruch 1 oder Anspruch 2, wobei das Oxidationsmittel ein Peroxid, eine Persulfonsäure oder ein Salz davon, Ozon, eine Peroxycarbonsäure oder ein Salz davon, eine Perphosphorsäure oder ein Salz davon, eine Perschwefelsäure oder ein Salz davon, eine Perchlorsäure oder ein Salz davon oder eine Periodsäure oder ein Salz davon umfasst, wobei das Oxidationsmittel gegebenenfalls Wasserstoffperoxid oder Perschwefelsäure umfasst, und/oder wobei das Oxidationsmittel in einer Menge von etwa 10 Gew.-% bis etwa 30 Gew.-% der Zusammensetzung vorliegt.

4. Zusammensetzung nach einem der Ansprüche 1-3, wobei die Hydroxylcarbonsäure Citronensäure oder Weinsäure ist, wobei die Hydroxylcarbonsäure gegebenenfalls in einer Menge von etwa 1 Gew.-% bis etwa 10 Gew.-% der Zusammensetzung vorliegt.

5. Zusammensetzung nach einem der Ansprüche 1-4, wobei das wenigstens eine anionische Tensid in einer Menge von etwa 0,001 Gew.-% bis etwa 5 Gew.-% der Zusammensetzung vorliegt.

6. Zusammensetzung nach einem der Ansprüche 1-5, wobei das Wasser in einer Menge von etwa 50 Gew.-% bis etwa 90 Gew.-% der Zusammensetzung vorliegt.

7. Zusammensetzung nach einem der Ansprüche 1-6, weiterhin umfassend einen Metallkorrosionsinhibitor, wobei der Metallkorrosionsinhibitor gegebenenfalls ein Azol oder ein Salz davon umfasst, oder wobei der Metallkorrosionsinhibitor gegebenenfalls 1,2,3-Triazol, 1,2,4-Triazol, 4-Amino-1,2,4-triazol, 3-Amino-1,2,4-triazol-5-thiol, 1H-Benzotriazol, 5-Methyl-1H-benzotriazol, 1H-Benzotriazol-1-methanol, 5,6-Dimethyl-1H-benzotriazol, 2-Amino-1,3,4-thiadiazol, 1H-Tetrazol, 5-Phenyl-1H-tetrazol, 5-Amino-1H-tetrazol oder eine Kombination davon umfasst, und/oder wobei der Metallkorrosionsinhibitor in einer Menge von etwa 0,01 Gew.-% bis etwa 10 Gew.-% der Zusammensetzung vorliegt.

8. Zusammensetzung nach einem der Ansprüche 1-7, weiterhin umfassend einen Chelatbildner, wobei der Chelatbildner gegebenenfalls eine Phosphonsäure oder ein Salz davon ist, oder wobei der Chelatbildner gegebenenfalls Hexamethylendiamintetra(methylenphosphonsäure), 1-Hydroxyethan-1,1-diphosphonsäure, Aminotris(methylenphosphonsäure), Ethylendiamintetra(methylenphosphonsäure), Tetramethylendiamintetra(methylenphosphonsäure), Diethylentriaminpenta(methylenphosphonsäure) oder ein Salz davon ist.

9. Zusammensetzung nach Anspruch 8, wobei der Chelatbildner eine Polyaminopolycarbonsäure umfasst, wobei der Chelatbildner gegebenenfalls Butylendiamintetraessigsäure, Diethylentriaminpentaessigsäure, Ethylendiamintetrapropionsäure, Triethylentetraminhexaessigsäure, 1,3-Diamino-2-hydroxypropan-N,N,N',N'-tetraessigsäure, Propylendiamintetraessigsäure, Ethylendiamintetraessigsäure, trans-1,2-Diaminocyclohexantetraessigsäure, Ethylendiamindiessigsäure, Ethylendiamindipropionsäure, 1,6-Hexamethylendiamin-N,N,N',N'-tetraessigsäure, N,N-Bis(2-hydroxybenzyl)ethylendiamin-N,N-diessigsäure, Diaminopropantetraessigsäure, 1,4,7,10-Tetraazacyclododecantetraessigsäure, Diaminopropanoltetraessigsäure oder (Hydroxyethyl)ethylendiamintriessigsäure umfasst.

10. Zusammensetzung nach Anspruch 8 oder Anspruch 9, wobei der Chelatbildner in einer Menge von etwa 0,01 Gew.-% bis etwa 10 Gew.-% der Zusammensetzung vorliegt.

11. Zusammensetzung nach einem der Ansprüche 1-10, weiterhin umfassend einen pH-Regulator, wobei der pH-Regulator gegebenenfalls eine Base oder eine Säure umfasst, wobei die Base gegebenenfalls Alkalihydroxid oder Ammoniumhydroxid ist, und/oder wobei der pH-Regulator in einer Menge von etwa 1 Gew.-% bis etwa 10 Gew.-% der Zusammensetzung vorliegt.

12. Zusammensetzung nach einem der Ansprüche 1-11, weiterhin umfassend ein quartäres Ammoniumsalz, wobei das quartäre Ammoniumsalz gegebenenfalls (Lauryldimethylammonio)acetat, Dodecyltrimethylammoniumchlorid oder Benzyldodecyldimethylammoniumbromid ist, und/oder wobei das quartäre Ammoniumsalz in einer Menge von etwa 0,01 Gew.-% bis etwa 1 Gew.-% der Zusammensetzung vorliegt.

13. Verfahren umfassend:
das Inkontaktbringen eines Halbleitersubstrats, das ein TaN-Merkmal enthält, mit einer Ätzzusammensetzung, um mindestens einen Teil des TaN-Merkmals zu entfernen,
wobei die Ätzzusammensetzung 1) ein Oxidationsmittel, 2) eine Hydroxylcarbonsäure, die mindestens zwei Carboxylgruppen umfasst, 3) ein anionisches Tensid und 4) Wasser umfasst, und
wobei die Zusammensetzung frei von einem Schleifmittel ist und einen pH-Wert von etwa 7 bis etwa 10 aufweist.

14. Verfahren nach Anspruch 13, weiterhin umfassend Spülen des Halbleitersubstrats mit einem Spüllösungsmittel nach dem Schritt des Inkontaktbringens, gegebenenfalls weiterhin umfassend Trocknen des Halbleitersubstrats nach dem Spülschritt, wobei das Verfahren gegebenenfalls Kupfer im Halbleitersubstrat nicht wesentlich entfernt.

15. Verfahren nach Anspruch 13 oder Anspruch 14, wobei das anionische Tensid eine Alkylethoxycarbonsäure oder ein Salz davon ist, wobei das anionische Tensid gegebenenfalls eine Verbindung der Formel (1): 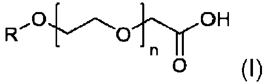 oder ein Salz davon ist, wobei R für C₁-C₁₄-Alkyl steht und n für eine ganze Zahl im Bereich von 1 bis 14 steht, und/oder wobei das anionische Tensid in einer Menge von etwa 0,001 Gew.-% bis etwa 5 Gew.-% der Zusammensetzung vorliegt.

## Revendications

1. Composition de gravure, comprenant :
1) un agent oxydant ;
2) un acide hydroxycarboxylique comprenant au moins deux groupes carboxyle ;
3) un tensioactif anionique, le tensioactif anionique comprenant un composé de formule (I) : 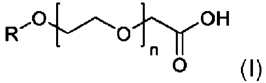 ou un sel de celui-ci, dans lequel R est un alkyle en C₁-C₁₄ et n est un nombre entier dans la plage allant de 1 à 14 ; et
4) de l'eau ;
la composition étant exempte d'abrasif et ayant un pH allant d'environ 7 à environ 10.

2. Composition selon la revendication 1, la composition ayant un pH allant d'environ 7 à environ 9,5.

3. Composition selon la revendication 1 ou la revendication 2, l'agent oxydant comprenant un peroxyde, un acide peroxysulfonique ou un sel de celui-ci, de l'ozone, un acide peroxycarboxylique ou un sel de celui-ci, un acide peroxophosphorique ou un sel de celui-ci, un acide peroxysulfurique ou un sel de celui-ci, un acide perchlorique ou un sel de celui-ci ou un acide periodique ou un sel de celui-ci, éventuellement l'agent oxydant comprenant du peroxyde d'hydrogène ou de l'acide peroxysulfurique, et/ou l'agent oxydant étant présent en une quantité allant d'environ 10 % en poids à environ 30 % en poids de la composition.

4. Composition selon l'une quelconque des revendications 1 à 3, l'acide hydroxycarboxylique étant l'acide citrique ou l'acide tartrique, éventuellement l'acide hydroxycarboxylique étant présent en une quantité allant d'environ 1 % en poids à environ 10 % en poids de la composition.

5. Composition selon l'une quelconque des revendications 1 à 4, le tensioactif anionique étant présent en une quantité allant d'environ 0,001 % en poids à environ 5 % en poids de la composition.

6. Composition selon l'une quelconque des revendications 1 à 5, l'eau étant présente en une quantité allant d'environ 50 % en poids à environ 90 % en poids de la composition.

7. Composition selon l'une quelconque des revendications 1 à 6, comprenant en outre un inhibiteur de corrosion des métaux, éventuellement l'inhibiteur de corrosion des métaux comprenant un azole ou un sel de celui-ci ou éventuellement l'inhibiteur de corrosion des métaux comprenant du 1,2,3-triazole, du 1,2,4-triazole, du 4-amino-1,2,4-triazole, du 3-amino-1,2,4-triazole-5-thiol, du 1H-benzotriazole, du 5-méthyl-1H-benzotriazole, du 1H-benzotriazole-1-méthanol, du 5,6-diméthyl-1H-benzotriazole, du 2-amino-1,3,4-thiadiazole, du 1H-tétrazole, du 5-phényl-1H-tétrazole, du 5-amino-1H-tétrazole ou une combinaison de ceux-ci et/ou l'inhibiteur de corrosion des métaux étant présent en une quantité allant d'environ 0,01 % en poids à environ 10 % en poids de la composition.

8. Composition selon l'une quelconque des revendications 1 à 7, comprenant en outre un agent chélatant, éventuellement l'agent chélatant étant un acide phosphonique ou un sel de celui-ci ou éventuellement l'agent chélatant étant l'acide hexaméthylènediaminetétra(méthylènephosphonique), l'acide 1-hydroxyéthane-1,1-diphosphonique, l'acide aminotris(méthylènephosphonique), l'acide éthylènediaminetétra(méthylènephosphonique), l'acide tétraméthylènediaminetétra(méthylènephosphonique), l'acide diéthylènetriaminepenta(méthylènephosphonique) ou un sel de ceux-ci.

9. Composition selon la revendication 8, l'agent chélatant comprenant un acide polyaminopolycarboxylique, éventuellement l'agent chélatant comprenant de l'acide butylènediaminetétraacétique, de l'acide diéthylènetriaminepentaacétique, de l'acide éthylènediaminetétrapropionique, de l'acide triéthylènetétraaminehexaacétique, de l'acide 1,3-diamino-2-hydroxypropane-N,N,N',N'-tétraacétique, de l'acide propylènediaminetétraacétique, de l'acide éthylènediaminetétraacétique, de l'acide trans-1,2-diaminocyclohexanetétraacétique, de l'acide éthylènediaminediacétique, de l'acide éthylènediaminedipropionique, de l'acide 1,6-hexaméthylènediamine-N,N,N',N'-tétraacétique, de l'acide N,N-bis(2-hydroxybenzyl)éthylènediamine-N,N-diacétique, de l'acide diaminopropanetétraacétique, de l'acide 1,4,7,10-tétraazacyclododécanetétraacétique, de l'acide diaminopropanoltétraacétique ou de l'acide (hydroxyéthyl)éthylènediaminetriacétique.

10. Composition selon la revendication 8 ou la revendication 9, l'agent chélatant étant présent en une quantité allant d'environ 0,01 % en poids à environ 10 % en poids de la composition.

11. Composition selon l'une quelconque des revendications 1 à 10, comprenant en outre un agent d'ajustement du pH, éventuellement l'agent d'ajustement du pH comprenant une base ou un acide, éventuellement la base étant un hydroxyde de métal alcalin ou un hydroxyde d'ammonium et/ou l'agent d'ajustement du pH étant présent en une quantité allant d'environ 1 % en poids à environ 10 % en poids de la composition.

12. Composition selon l'une quelconque des revendications 1 à 11, comprenant en outre un sel d'ammonium quaternaire, éventuellement le sel d'ammonium quaternaire étant le (lauryldiméthylammonio)acétate, le chlorure de dodécyltriméthylammonium ou le bromure de benzyldodécyldiméthylammonium et/ou le sel d'ammonium quaternaire étant présent en une quantité allant d'environ 0,01 % en poids à environ 1 % en poids de la composition.

13. Procédé, comprenant :
la mise en contact d'un substrat en semi-conducteur contenant une structure en TaN avec une composition de gravure pour éliminer au moins une partie de la structure en TaN,
la composition de gravure comprenant 1) un agent oxydant ; 2) un acide hydroxycarboxylique comprenant au moins deux groupes carboxyle ; 3) un tensioactif anionique ; et 4) de l'eau ; et
la composition étant exempte d'abrasif et ayant un pH allant d'environ 7 à environ 10.

14. Procédé selon la revendication 13, comprenant en outre le rinçage du substrat en semi-conducteur avec un solvant de rinçage après l'étape de mise en contact, comprenant éventuellement en outre le séchage du substrat en semi-conducteur après l'étape de rinçage, éventuellement le procédé n'éliminant sensiblement pas le cuivre présent dans le substrat en semi-conducteur.

15. Procédé selon la revendication 13 ou la revendication 14, le tensioactif anionique étant un acide carboxylique alkylique éthoxylé ou un sel de celui-ci, éventuellement le tensioactif anionique étant un composé de formule (I) : 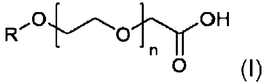 ou un sel de celui-ci, dans lequel R est un alkyle en C₁-C₁₄ et n est un nombre entier dans la plage allant de 1 à 14, et/ou le tensioactif anionique étant présent en une quantité allant d'environ 0,001 % en poids à environ 5 % en poids de la composition.
